# EUROPEAN PATENT APPLICATION

(11) **EP 3 252 107 A1**
(43) Date of publication of application: **06.12.2017**
(21) Application number: 16743708.6
(22) Date of filing: 28.01.2016
(51) Int. Cl.: C08L 83/04, C08K 3/22, H01L 23/29

(54) **COMPOSITION FOR ORGANIC ELECTRONIC ELEMENT ENCAPSULANT AND ENCAPSULANT FORMED USING SAME**

(30) Priority: 29.01.2015 KR 20150014573
(71) Applicant: Momentive Performance Materials Korea Co., Ltd., Seoul 08510 (KR)
(72) Inventor: YU, Sun, Seoul 08510 (KR); CHOI, Hyun-Sang, Seoul 08510 (KR); KIM, Nan Soo, Seoul 08510 (KR); KIM, Seong-Gi, Hwaseong-si Gyeonggi-do 18457 (KR)
(74) Representative: Goddar, Heinz J.
(86) International application number: PCT/KR2016/000943
(87) International publication number: WO 2016/122230

(57) **Abstract**

The present application relates to a composition for an encapsulant and an encapsulant formed using the same. The composition for an encapsulant according to one embodiment of the present application includes 1) a silicone resin; 2) one or more types of moisture absorbents; and 3) one or more types of photoinitiators.

## Description

### [Technical Field]

The present application claims priority to and the benefits of Korean Patent Application No. 10-2015-0014573, filed with the Korean Intellectual Property Office on January 29, 2015, the entire contents of which are incorporated herein by reference.

The present application relates to a composition for an organic electronic device encapsulant and an encapsulant formed using the same.

### [Background Art]

Generally, an organic electronic device is a device in which a phenomenon such as light emission or electricity flow occurs when charge is injected to an organic layer provided between an anode and a cathode, and devices having various functions may be manufactured depending on organic materials selected.

As a representative example, an organic light emitting diode (OLED) has received attention as a next-generation flat display due to its properties of being thin, light and having excellent color sense, and it may be manufactured on existing glass substrates, inorganic matter substrates including silicon, metal substrates and flexible substrates such as plastic substrates or metal foil. Such an organic electronic device is very vulnerable to moisture and oxygen, and has a disadvantage of significantly reducing light emission efficiency and a lifespan when exposed to the atmosphere or when moisture is brought into the panel from the outside.

In view of such a problem, attempts to block moisture and oxygen inflowing from the outside by using a glass cap or a metal cap, using an encapsulating film using a laminating method, or depositing inorganic matters have been made. In addition, there are methods of obtaining adhesion and sealing by progressing a curing process after applying a curing film or a curing material on an organic layer or metal layer surface.

However, the glass cap has problems in manufacturing large area devices due to mechanical fracturing and the like, and the metal cap has problems in terms of a process caused by a difference in the thermal expansion coefficient with a substrate. In addition, an adhesive film using the laminating method has a problem of moisture and oxygen inflow through an interface of the film adhesion surface, and existing processes depositing organic matters under vacuum and sputtering inorganic matters under vacuum have a problem in having low productivity since they need to deposit the inorganic matters in a multilayer using a sputtering method under vacuum in order to prevent water and oxygen inflow through an interface at the sputtering top, and also have a problem of productivity decrease and in mass production since the organic matters and the inorganic matters need to be formed in a multilayer under vacuum.

In addition, a liquid encapsulation method has a disadvantage in that byproducts produced during a curing process, unreacted residues of a curing initiator, or the like remain inside a sealed structure inhibiting the drive of an organic electronic device or shortening a lifespan.

Furthermore, in a metal cap method installing a moisture absorbent inside a panel when encapsulating an organic electronic device, an extension protruding to a certain height is formed in the metal cap structure to use the moisture absorbent and the metal cap is lastly sealed with a substrate using an adhesive, or when sealing an organic light emitting diode by forming a glass cap through glass processing, a method of sealing with a substrate by installing a moisture absorbent inside a certain groove using a method such as sand blast or etching is used. In such existing methods, metal cap processing becomes difficult when a panel becomes large-sized due to increased inner space of encapsulation, and a glass cap may cause a problem of being readily damaged by an external pressure.

### [Disclosure]

### [Technical Problem]

The present application is directed to providing a composition that may prepare an encapsulant capable of enhancing a lifespan of an organic electronic device and effectively blocking oxygen, moisture and the like inflowing from the outside, and an encapsulant using the same.

### [Technical Solution]

One embodiment of the present application provides a composition for an encapsulant including,
1) a silicone resin;
2) one or more types of moisture absorbents; and
3) one or more types of photoinitiators.

Another embodiment of the present application provides an encapsulant using the composition for an encapsulant.

Still another embodiment of the present application provides an organic electronic device including the encapsulant.

### [Advantageous Effects]

A composition for an encapsulant according to one embodiment of the present application can prepare an encapsulant capable of enhancing a lifespan of an organic electronic device and effectively blocking oxygen, moisture and the like inflowing from the outside. In addition, general compositions that have been used as existing encapsulants have a disadvantage of losing their properties by being mixed with other materials after sealed to an organic electronic device, or not maintaining a gap between sealed surfaces due to a nonuniform pressure applied when sealed. However, by using a curing-type composition, the gap does not readily change in the composition for an encapsulant according to one embodiment of the present application even when a pressure is applied since the cured material has strength, and therefore, the gap can be well-maintained after sealing the composition to the organic electronic device.

### [Mode for Disclosure]

Hereinafter, the present application will be described in detail.

An organic EL device is a polycrystalline semiconductor device, is used in a back light and the like of liquid crystals for obtaining high luminescent light emission under a low voltage, and is expected as a flat panel display device. However, an organic EL device is extremely weak for moisture, an interface between a metal electric filed and an organic EL layer is detached due to the influence of moisture, a metal is oxidized to increase resistance, an organic matter itself is deteriorated due to moisture, and as a result, light emission does not occur leading to a problem of reducing luminance.

In view of the above, methods of encapsulating an organic EL device with a curing-type composition have been developed. As existing encapsulating methods, a method of molding an organic EL device with an acrylic resin, a method of adding a moisture absorbent into an encapsulating resin of an organic EL device to block the organic EL device from moisture, and the like, have been proposed.

Among these, a method of mixing an encapsulating resin and a moisture absorbent has been most widely used, however, an encapsulant that is not a curing type has a disadvantage of lowering a production yield when a post process is progressed since the encapsulant is difficult to tolerate a process threshold under high temperature and high pressure.

The present application is directed to providing a curing-type encapsulant composition that may prepare an encapsulant capable of enhancing a lifespan of an organic electronic device and effectively blocking oxygen, moisture and the like inflowing from the outside, and, in addition thereto, is capable of having process stability when a post process is progressed by introducing a curing-type system, and an encapsulant using the same.

A composition for an encapsulant according to one embodiment of the present application includes 1) a silicone resin; 2) one or more types of moisture absorbents; and 3) one or more types of photoinitiators.

In the composition for an encapsulant according to one embodiment of the present application, specific examples of the silicone resin may include an organopolysilicone-based resin and the like, but are not limited thereto. In addition, examples of the organopolysilicone-based resin are described below in more detail.

In the organopolysilicone-based resin, one or more types of functional groups selected from the group consisting of an alkyl group, an aryl group and an alkenyl group may bond to the silicon main chain.

Specific examples of the alkyl group may include a methyl group, an ethyl group, a propyl group, a 1-methylethyl group, a butyl group, a 1-methylpropyl group, a 2-methylpropyl group, a 1,1-dimethylethyl group, a pentyl group, a 1-methylbutyl group, a 1-ethylpropyl group, a 2-methylbutyl group, a 3-methylbutyl group, a 1,2-dimethylpropyl group, a 2,2-dimethylpropyl group, a hexyl group, a heptyl group, an octyl group, a nonyl group, a decyl group, a cycloalkyl group and the like, but are not limited thereto.

Specific examples of the aryl group may include a phenyl group; a naphthyl group; an alkylaryl group such as a tolyl group and a xylyl group; an arylalkyl group such as a benzyl group and a phenethyl group, and the like, but are not limited thereto.

The alkenyl group typically has 2 to 10 carbon atoms, and specific examples thereof may include a vinyl group, an allyl group, a methacrylic group, a methyl methacrylic group, an acrylic group and the like, but are not limited thereto.

The organopolysilicone-based resin is preferably one or more types selected from among compounds represented by the following Chemical Formula 1.

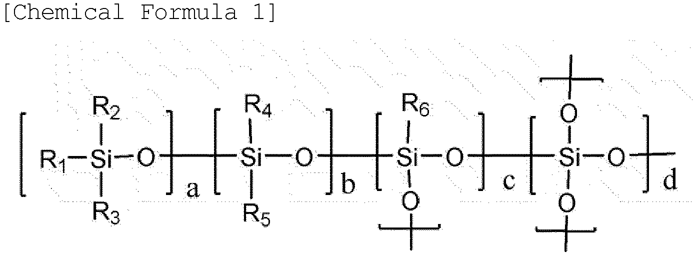

In Chemical Formula 1,
R₁ to R₆ are the same as or different from each other, and may be each independently selected from the group consisting of hydrogen, an alkyl group, an alkenyl group, an aryl group, a glycidyl group, an isocyanate group, a hydroxyl group, a carboxyl group, a vinyl group, an acrylate group, a methacrylate group, an epoxide group, a cyclic ether group, a sulfide group, an acetal group, a lactone group and an amide group, and
a, b, c and d are each independently a real number of 0 to 1, and (a+b+c+d) is 1.

The organopolysilicone-based resin may have a weight average molecular weight of 100 to 1,000,000, and 1,000 to 50,000, however, the weight is not limited thereto.

The content of the silicone resin may be from 1% by weight to 80% by weight based on the total weight of the composition for an encapsulant, but is not limited thereto. When the silicone resin content is in the range of 1% by weight to 80% by weight, a moisture absorbent amount capable of maintaining a sufficient moisture-absorbing ability while maintaining excellent miscibility with the moisture absorbent may be mixed. When the silicone resin has a content of less than 1% by weight, mixing with the moisture absorbent is impossible, and when the content is greater than 80% by weight, mixing with the moisture absorbent capable of obtaining a sufficient moisture absorbing ability to protect a device may not be obtained.

In the composition for an encapsulant according to one embodiment of the present application, the moisture absorbent may perform a role of providing a moisture absorbing property to the composition for an encapsulant, and controlling thixotropy. Specific examples of the moisture absorbent may include one type of metal powders such as alumina, metal oxides, organic metal oxides, metal salts or phosphorous pentoxide (P₂O₅), or mixtures of two or more types thereof, but are not limited thereto.

Specific examples of the metal oxide may include lithium oxide (Li₂O), sodium oxide (Na₂O), barium oxide (BaO), calcium oxide (CaO), magnesium oxide (MgO) and the like, and examples of the metal salt may include sulfates such as lithium sulfate (Li₂SO₄), sodium sulfate (Na₂SO₄), calcium sulfate (CaSO₄), magnesium sulfate (MgSO₄), cobalt sulfate (CoSO₄), gallium sulfate (Ga₂(SO₄)3), titanium sulfate (Ti(SO₄)₂) or nickel sulfate (NiSO₄), metal halides such as calcium chloride (CaCl₂), magnesium chloride (MgCl₂), strontium chloride (SrCl₂), yttrium chloride (YCl₃), copper chloride (CuCl₂), cesium fluoride (CsF), tantalum fluoride (TaF₅), niobium fluoride (NbF₅), lithium bromide (LiBr), calcium bromide (CaBr₂), cesium bromide (CeBr₃), selenium bromide (SeBr₄), vanadium bromide (VBr₃), magnesium bromide (MgBr₂), barium iodide (BaI₂) or magnesium iodide (MgI₂); or metal chlorates such as barium perchlorate (Ba(ClO₄)₂) or magnesium perchlorate (Mg(ClO₄)2), and the like, but are not limited thereto.

The metal oxides may be mixed to the composition in a state of properly processing the moisture absorbent. For example, the encapsulant may be a thin film having a thickness of 30 µm or less depending on the type of an organic electronic device to use the encapsulant, and in this case, a process of grinding the moisture absorbent may be required. For the moisture absorbent grinding, processes such as a 3-roll mill, a bead mill or a ball mill may be used.

The content of the moisture absorbent may be from 10% by weight to 90% by weight based on the total weight of the composition for an encapsulant, but is not limited thereto. When the moisture absorbent content is less than 10% by weight based on the total weight of the composition for an encapsulant, a sufficient moisture absorbing ability to protect a device is difficult to obtain, and when the content is greater than 90% by weight, viscosity excessively increases making it impossible to use the encapsulant in the process.

In the composition for an encapsulant according to one embodiment of the present application, the photoinitiator generates free radicals when exposed to actinic rays although it is thermally inactive. As the photoinitiator, substituted or unsubstituted multinuclear quinone, a compound having carbon atoms in two rings among conjugated hydrocarbon-based, such as 2-benzyl-2-(dimethylamino)-1-(4-morpholinophenyl)-1-butanone, 2,2-dimethoxy-2-phenylacetophenone, 9,10-anthraquinone, 2-methylanthraquinone, 2-ethylanthraquinone, 2-tert-butylanthraquinone, octamethylanthraquinone, 1,4-naphthoquinone, 9,10-phenanthrenequinone, benz(benza)anthracene-7,12-dione, 2,3-naphthacene-5,12-dione, 2-methyl-1,4-naphthoquinone, 1,4-dimethylanthraquinone, 2,3-dimethylanthraquinone, 2-phenylanthraquinone, 2,3-diphenylanthraquinone, retenequinone, 7,8,9,10-tetrahydronaphthracene-5,12-dione and 1,2,3,4-tetrahydrobenz(tetrahydrobenza)-anthracene-7,12-dione, however, the photoinitiator is not limited thereto.

The content of the photoinitiator may be from 0.1% by weight to 10% by weight based on the total weight of the composition for an encapsulant, but is not limited thereto. When the photoinitiator content is less than 0.1% by weight based on the total weight of the composition for an encapsulant, the number of active radicals facilitating the curing is small leading to a problem of the curing not being progressed even when irradiating intense ultraviolet light, and when the content is greater than 10% by weight, outgas is generated under a temperature condition of lower than 100°C after the curing causing a concern of shortening a lifespan of an organic light emitting device.

The composition for an encapsulant according to one embodiment of the present application may further include an inorganic filler. The filler makes a moving path of water or moisture penetrating into an encapsulating structure longer and thereby suppresses the penetration, and is capable of maximizing a property of blocking water and moisture through an interaction with a matrix structure of a resin, a moisture absorbent and the like. In one embodiment of the present application, one type of clay, talc, silica, barium sulfate, aluminum hydroxide, potassium carbonate, magnesium carbonate, zeolite, zirconia, titania, montmorillonite or the like, or a mixture of two or more types thereof may be used as the filler described above, however, the filler is not limited thereto.

In addition, in order to enhance binding efficiency of a filler and a resin, a product surface treated with an organic material may be used as the filler, or a coupling agent may be additionally added thereto to be used.

The content of the inorganic filler may be greater than 0% by weight and less than or equal to 20% by weight based on the total weight of the composition for an encapsulant, but is not limited thereto. When the inorganic filler content is greater than 20% by weight based on the total weight of the composition for an encapsulant, thixotropy excessively increases similar to when the moisture absorbent is mixed in 95% by weight or greater, and viscosity having a level that is difficult to use in a process is obtained.

The composition for an encapsulant according to one embodiment of the present application may further include a monomer known in the art in order to control a curing rate of the silicone resin material. Specific examples of the monomer may include acrylate-based monomers, methacrylate-based monomers, siloxane-based monomers and the like, but are not limited thereto.

As the monomer, triethylolpropaneethoxy triacrylate, t-butyl (meth)acrylate, 1,5-pentanediol di(meth)acrylate, N,N-diethylaminoethyl (meth)acrylate, ethylene glycol di(meth)acrylate, 1,4-butanediol di(meth)acrylate, diethylene glycol di(meth)acrylate, hexamethylene glycol di(meth)acrylate, 1,3-propanediol di(meth)acrylate, decamethylene glycol di(meth)acrylate, 1,4-cyclohexanediol di(meth)acrylate, 2,2-dimethylolpropane di(meth)acrylate, glycerol di(meth)acrylate, tripropylene glycol di(meth)acrylate, glycerol tri(meth)acrylate, trimethylolpropane tri(meth)acrylate, pentaerythritol tri(meth)acrylate, polyoxyethylated trimethylolpropane tri(meth)acrylate, 2,2-di-(p-hydroxyphenyl)propane diacrylate, pentaerythritol tetra(meth)acrylate, 2,2-di-(p-hydroxyphenyl)propane dimethacrylate, triethylene glycol diacrylate, polyoxyethyl-2,2-di-(p-hydroxyphenyl)propane dimethacrylate, di-(3-methacryloxy-2-hydroxypropyl)ether of bisphenol-A, di-(2-methacryloxyethyl)ether of bisphenol-A, di-(3-acryloxy-2-hydroxypropyl)ether of bisphenol-A, di-(2-acryloxyethyl)ether of bisphenol-A, di-(3-methacryloxy-2-hydroxypropyl)ether of 1,4-butanediol, triethylene glycol dimethacrylate, polyoxypropyltrimethylolpropane triacrylate, butylene glycol di(meth)acrylate, 1,2,4-butanetriol tri(meth)acrylate, 2,2,4-trimethyl-1,3-pentanediol di(meth)acrylate, 1-phenyl ethylene-1,2-dimethacrylate, diallyl fumarate, styrene, 1,4-benzenediol dimethacrylate, 1,4-diisopropenyl benzene, 1,3,5-triisopropenyl benzene, silicone-based monomers, silicone acrylate-based monomers, silicone urethane-based monomers and the like may be included, however, the monomer is not limited thereto.

In addition, the composition for an encapsulant according to one embodiment of the present application may include one or more additives such as a curing catalyst, a viscosity controller, a curing agent, a dispersant, a stabilizer or a curing accelerator depending on the application. These additives may be used either alone or as a mixture of two or more types.

In addition, an encapsulant according to one embodiment of the present application uses the composition for an encapsulant. More specifically, an encapsulant according to one embodiment of the present application may include 1) a silicone resin; 2) one or more types of moisture absorbents; and 3) one or more types of photoinitiators.

In the encapsulant according to one embodiment of the present application, the silicone resin, the moisture absorbent, the photoinitiator and the like are the same as described above, and therefore, specific descriptions thereon will not be repeated.

The encapsulant according to one embodiment of the present application may be formed using methods known in the art except that the composition for an encapsulant described above is used. More specifically, the encapsulant may be formed using a method such as applying, coating or printing the composition for an encapsulant on a substrate, however, the method is not limited thereto.

The composition for an encapsulant according to one embodiment of the present application prepares an encapsulant capable of enhancing a lifespan of an organic electronic device and effectively blocking oxygen, moisture and the like inflowing from the outside. In addition, general getters that have been used as existing encapsulants have a disadvantage of losing their properties by being mixed with other materials after sealed to an organic electronic device, or not maintaining a gap between sealed surfaces due to a nonuniform pressure applied when sealed. However, by using a curing-type composition, the gap does not readily change in the composition for an encapsulant according to one embodiment of the present application even when a pressure is applied since the cured material has strength, and therefore, the gap can be well-maintained after sealing the composition to an organic electronic device.

The encapsulant according to one embodiment of the present application may be used in encapsulating and thereby protecting various objects. Particularly, the encapsulant may be effective in protecting objects including a device sensitive to external components such as water or moisture. Examples of the object that the encapsulant may be used in may include organic electronic devices such as photovoltaic devices, rectifiers, transmitters or organic light emitting diodes (OLED); solar cells; secondary batteries or the like, but are not limited thereto.

The encapsulant may efficiently fix and support an upper substrate and a lower substrate while exhibiting excellent moisture blocking and optical properties in an organic electronic device. In addition, the encapsulant exhibits excellent transparency by preparing a moisture absorbent in nano sizes and uniformly dispersing the moisture absorbent into the composition for an encapsulant, and may be formed into a stable encapsulant regardless of the type of the organic electronic device such as top emission or bottom emission.

The organic electronic device may be provided using common constitutions known in the art except that the encapsulant is formed using the materials described above. For example, as lower and/or upper substrates, glass, metals, polymer films and the like commonly used in the art may be used. In addition, the organic electronic device may include, for example, a pair of electrodes and an organic material layer formed between the pair of electrodes. Herein, any one of the pair of electrodes may be formed as a transparent electrode. In addition, examples of the organic material layer may include a hole transfer layer, a light emitting layer, an electron transfer layer and the like.

Hereinafter, the present specification will be described in more detail with reference to examples. However, the following examples are for illustrative purposes only, and the present specification is not limited thereto.

### <Example>

### <Example 1>

51 g of a silicone resin (1) (methacrylate polydimethylsiloxane, Aldrich), 45 g of a moisture absorbent (CaO, Yoshizawa) and 4 g of a photoinitiator (Irgacure 369) manufactured by BASF Corporation were first mixed using a paste mixer. The mixed composition was placed in a 3 roll mill, and a milling process was progressed three times to prepare a binder composition for a getter. A 100 cc syringe was filled with the mixture, and after sufficiently removing bubbles using a centrifuge, the result was stored in a glove box at room temperature under anhydrous nitrogen atmosphere.

### <Example 2>

A composition was prepared in the same manner as in Example 1 except that the silicone resin (1) of Example 1 was changed to 41 g of methacrylate polydimethylsiloxane (Aldrich), and 10 g of vinylpolyvinyldimethylsiloxane (Aldrich) was added as a silicone resin (2).

### <Comparative Example 1>

A composition was prepared in the same manner as in Example 1 except that the silicone resin (1) of Example 1 was changed to 55 g, and the moisture absorbent (CaO, Yoshizawa) was changed to 45 g.

### <Comparative Example 2>

A composition was prepared in the same manner as in Example 1 except that the silicone resin (1) of Example 1 was changed to 51 g of acryl-based resin manufactured by Miwon Commercial Co., Ltd..

### <Comparative Example 3>

A composition was prepared in the same manner as in Example 1 except that the silicone resin (1) of Example 1 was changed to 1 g of methacrylate polydimethylsiloxane (Aldrich), and the moisture absorbent (CaO, Yoshizawa) was changed to 95 g.

### <Comparative Example 4>

A composition was prepared in the same manner as in Example 1 except that the silicone resin (1) of Example 1 was changed to 91 g of methacrylate polydimethylsiloxane (Aldrich), and the moisture absorbent (CaO, Yoshizawa) was changed to 5 g.

**[Table 1]**

| Compon ent | Material | Content (% by Weight) | | | | | |
|---|---|---|---|---|---|---|---|
| | | Exam ple 1 | Exam ple 2 | Compar ative Exampl e 1 | Compar ative Exampl e 2 | Compar ative Exampl e 3 | Compar ative Exampl e 4 |
| Polyme r Resin | Silicon e Resin (1) | 51 | 41 | 55 | 0 | 1 | 91 |
| | Silicon Resin (2) | 0 | 10 | 0 | 0 | 0 | 0 |
| | Acryl-Based Resin | 0 | 0 | 0 | 51 | 0 | 0 |
| Photo-initia tor | Irgacur e 369 | 4 | 4 | 0 | 4 | 4 | 4 |
| Moistu | Calcium | 45 | 45 | 45 | 45 | 95 | 5 |
| re Absorb ent | Oxide | | | | | | |

Properties of the compositions of Examples 1 and 2, and Comparative Examples 1 to 4 prepared above were evaluated, and the results are shown in the following Table 2.

**[Table 2]**

| | Examp le 1 | Examp le 2 | Comparati ve Example 1 | Comparati ve Example 2 | Comparati ve Example 3 | Comparati ve Example 4 |
|---|---|---|---|---|---|---|
| Thixotropic Index | 2.2 | 5.1 | 2.2 | 7.5 | No Blending | 1.1 |
| Curing Energy (UV-A, mJ/cm2) | <3,00 0 | <3,00 0 | Not Cured | >50,000 | - | <3,000 |
| Shelf Life @40°C (hr) | >2,00 0 | >2,00 0 | >2,000 | <100 | - | >2,000 |
| Discharge Property | Excel lent | Excel lent | Excellent | Poor | - | Excellent |
| Vacuum Sealing Processability | Excel lent | Excel lent | Poor | Poor | - | Fair |
| Moisture Absorbing Rate | >15% | >15% | >15% | >15% | - | <5% |

As for the thixotropic index (T.I), viscosity for each shear was analyzed using a rheometer. Among these values, T.I was obtained as a value dividing the viscosity values at 3 I/s and 30 I/s.

As for the curing energy, UV in a UV-A wavelength range was irradiated using a photo rheometer (omni cure) and an increase in the viscosity during exposure was identified, and the section with no viscosity increase over time was determined as curing energy.

As for the shelf life, each of the samples was located under a 40°C condition, viscosity by time was regularly checked, and then the time at which the viscosity increase passed 50% was identified.

As for the discharge property, a discharged amount was obtained by discharging for 10 seconds with a pressure of 250 Kpa using a 20 G size nozzle with a musashi 70 cc syringe, and the discharge property was determined to be favorable when the discharged amount was able to be controlled between 0.001 g and 0.05 g.

As for the vacuum sealing processability, line dispensing was carried out with the sample on a gorilla glass having a thickness of 0.5 mm, then sealing was performed so as to have a gap of 100 µm using the same glass, and the result was left unattended for 1 week in a vacuum chamber. The vacuum sealing processability was determined to be favorable when the dispensing line width did not change.

As for the amount of moisture absorption, 3 g of each of the samples was thinly rolled in a petri dish, left unattended for 7 days under a 100% RH condition, and the amount of moisture absorption for the 3 g was obtained by identifying the changed amount in the sample weight.

As is seen from the results, the composition for an encapsulant according to one embodiment of the present application prepares an encapsulant capable of enhancing a lifespan of an organic electronic device and effectively blocking oxygen, moisture and the like inflowing from the outside. In addition, general compositions that have been used as existing encapsulants have a disadvantage of losing their properties by being mixed with other materials after sealed to an organic electronic device, or not maintaining a gap between sealed surfaces due to a nonuniform pressure applied when sealed. However, by using a curing-type composition, the gap does not readily change in the composition for an encapsulant according to one embodiment of the present application even when a pressure is applied since the cured material has strength, and therefore, the gap can be well-maintained after sealing the composition to an organic electronic device.

## Claims

1. A composition for an encapsulant comprising:
1) a silicone resin;
2) one or more types of moisture absorbents; and
3) one or more types of photoinitiators.

2. The composition for an encapsulant of Claim 1, wherein the silicone resin is an organopolysilicone-based resin.

3. The composition for an encapsulant of Claim 2, wherein the organopolysilicone-based resin is one or more types selected from among compounds represented by the following Chemical Formula 1: 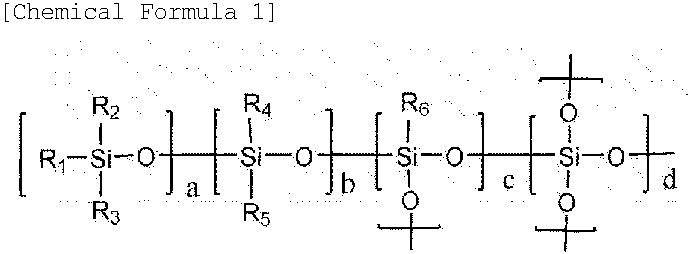 wherein, in Chemical Formula 1,
R₁ to R₆ are the same as or different from each other, and each independently selected from the group consisting of hydrogen, an alkyl group, an alkenyl group, an aryl group, a glycidyl group, an isocyanate group, a hydroxyl group, a carboxyl group, a vinyl group, an acrylate group, a methacrylate group, an epoxide group, a cyclic ether group, a sulfide group, an acetal group, a lactone group and an amide group; and
a, b, c and d are each independently a real number of 0 to 1, and (a+b+c+d) is 1.

4. The composition for an encapsulant of Claim 1, wherein a content of the silicone resin is from 1% by weight to 80% by weight based on a total weight of the composition for an encapsulant.

5. The composition for an encapsulant of Claim 1, wherein the moisture absorbent includes one or more types selected from the group consisting of metal powders, metal oxides, organic metal oxides, metal salts or phosphorous pentoxide (P₂O₅).

6. The composition for an encapsulant of Claim 1, wherein a content of the moisture absorbent is from 10% by weight to 90% by weight based on a total weight of the composition for an encapsulant.

7. The composition for an encapsulant of Claim 1, further comprising one or more types of inorganic fillers selected form the group consisting of clay, talc, silica, barium sulfate, aluminum hydroxide, potassium carbonate, magnesium carbonate, zeolite, zirconia, titania and montmorillonite.

8. The composition for an encapsulant of Claim 1, wherein a content of the photoinitiator is from 0.1% by weight to 10% by weight based on a total weight of the composition for an encapsulant.

9. The composition for an encapsulant of Claim 1, further comprising one or more types selected from the group consisting of acrylate-based monomers, methacrylate-based monomers, siloxane-based monomers, silicone-based monomers, silicone acrylate-based monomers and silicone urethane-based monomers.

10. An encapsulant formed using the composition for an encapsulant of any of Claims 1 to 9.

11. An organic electronic device comprising the encapsulant of Claim 10.
